# EUROPEAN PATENT SPECIFICATION

(11) **EP 0 654 818 B1**
(45) Date of publication and mention of the grant of the patent: **13.12.2000**
(21) Application number: 94306586.2
(22) Date of filing: 07.09.1994
(51) Int. Cl.: H01L 21/48, H05K 1/09

(54) **Semiconductor device with solder bump and process for manufacturing the same**
Halbleitervorrichtung mit Lötstellen und Verfahren zur Herstellung
Dispositif à semiconducteur avec plots de soudure et procédé de fabrication

(30) Priority: 19.11.1993 JP 29032793; 25.03.1994 JP 5580694
(43) Date of publication of application: 24.05.1995
(73) Proprietor: Citizen Watch Co., Ltd., Shinjuku-ku Tokyo (JP)
(72) Inventor: Mimura, Seiichi, Citizen Watch Co., Ltd., Tanashi-shi, Tokyo (JP); Komatsu, Katsuji, Citizen Watch Co., Ltd., Tanashi-shi, Tokyo (JP); Iinuma, Yoshio, Citizen Watch Co., Ltd., Tokorozawa-shi Saitama-ken (JP); Terashima, Kazuhiko, Citizen Watch Co., Ltd., Tokorazawa-shi, Saitama-ken (JP); Miyazaki, Taichi, Citizen Watch Co., Ltd., Tokorazawa-shi, Saitama-ken (JP); Ichikawa, Shingo, Citizen Watch Co., Ltd., Tanashi-shi, Tokyo (JP); Kaneko, Hiroyuki, Citizen Watch Co., Ltd., Tanashi-shi, Tokyo (JP); Shimizu, Junichiro, Citizen Watch Co., Ltd., Tanashi-shi, Tokyo (JP); Ikeda, Ienobu, Citizen Watch Co., Ltd., Tanashi-shi, Tokyo (JP)
(74) Representative: Linn, Samuel Jonathan

(56) References cited:
- DE-A- 3 312 725
- US-A- 4 772 523
- US-A- 4 946 563
- US-A- 5 126 016
- PATENT ABSTRACTS OF JAPAN vol. 15, no. 498 (E-1146) 17 December 1991 & JP-A-03 218 056 (TOSHIBA CORP.) 25 September 1991

## Description

The present invention relates to a semiconductor device having solder bumps with improved affinity between pad electrodes and solder bumps, and to a process for manufacturing this device.

Semiconductor devices using a resin substrate having a number of electrodes have been developed along with high density mounting of IC chips in recent years. A typical example of such a semiconductor device is the pin-glid array (hereinafter abbreviated to PGA). PGA has a construction in which IC chips are mounted on one side and sealed with a resin, and a number of pins are provided on the other side. Although PGA has an advantage that it is attachable to and removable from the mother board, it is large in size because of the use of pins. It is difficult to fabricate it small, and there are thus limitations to high density mounting.

Ball-glid array (hereinafter abbreviated to BGA) has been developed as a small-type resin sealing semiconductor device with an expectation of being replaced for PGA. A general construction of BGA is illustrated by reference to the drawings.

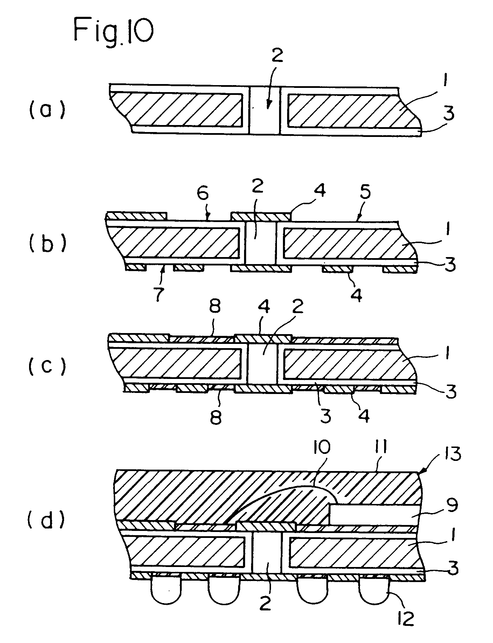

Outline for manufacturing a conventional BGA is first described with reference to Figures 10(a) to 10(d), Figure 11, and Figure 12.

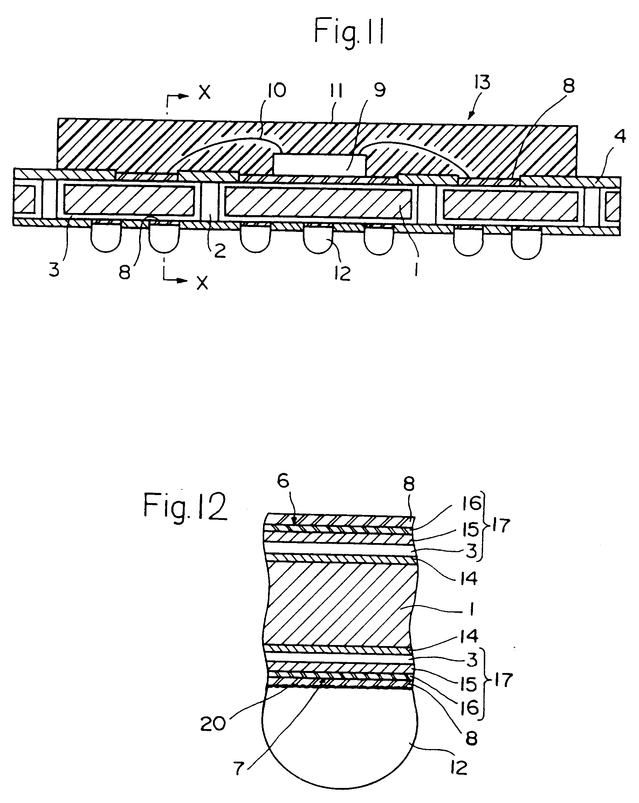

Figures 10(a) to 10(d) are sectional views of resin substrate 1 in each step of manufacturing conventional BGA, Figure 11 is a sectional view of resin substrate as completed, and Figure 12 is an enlarged sectional view of a main portion sectioned along line X-X of Figure 11 and shows a multi-layer construction of plated metals on said resin substrate 1.

As shown in Figure 10(a), resin substrate 1 is formed from a glass epoxy resin or the like with a thickness of about 0.2 mm. The resin substrate 1 has a laminated copper foil (see Figure 11) with a thickness of 18 µm on both the upper and lower sides, and further a number of through-holes 2 provided therethrough by a cutting drill or the like. The surfaces of resin substrate 1, together with walls of through-holes 2, are washed and the whole surface is plated electrolytically and non-electrolytically to form a copper layer 3. This copper layer 3 is provided also inside the through-holes 2.

A plating resist is then laminated on the resin substrate 1, and the resist is irradiated and developed to form a pattern mask, following which pattern etching is performed using CuCl₂ + H₂O₂ which is a common circuit board etching solution. In this manner, an acrylic type dry film 4 is formed on the parts, excluding at least the parts where IC chips, bonding wires, and solder bumps are joined.

Figure 10(b) is a sectional view of the resin during lamination of the dry film. On the upper side of the resin substrate 1 are formed opening spaces for exposing a die pattern 5 for IC chips and connection electrodes 6 for wire bonding, on the lower side formed are opening spaces for exposing pad electrodes 7 for forming solder bumps. These connection electrodes 6 and pad electrodes 7 are joined via through-holes 2.

Next, as shown in Figure 10(c), a nickel plated layer with a thickness of about 2-5 µm is provided (see Figure 12) on die pattern 5, connection electrodes 6, and pad electrodes 7 exposed from dry film 4 on the both upper and lower sides of the resin substrate 1. Further, a gold plated layer 8 with a thickness of about 0.3-0.7 µm, having excellent conductivity, is provided on the nickel plated layer.

Then, as shown in Figure 10(d), IC chip 9 is mounted on said die pattern 5 on the upper side of the resin substrate 1. After connecting IC chip 9 and connection electrode 6 by bonding wire 10 made from gold, the IC chip 9 and the bonding wire 10 are sealed with thermoset sealing resin 11 by transfer molding, thereby ensuring light-shielding and protection of IC chip 9. Further, solder bumps 12 are formed on the metal layer 8 on pad electrodes 7 on the lower side of resin substrate 1. BGA 13, as shown in Figure 11, is completed in this manner, and connected to the pattern on the mother board, not shown in the drawings, by solder bumps 12.

Details of main parts of conventional BGA substrate are then illustrated referring to Figure 12.

As mentioned above, a copper plated layer 3 is formed by electrolytic and non-electrolytic plating all over the surface of copper foil 14 with a thickness of about 18 µm on the resin substrate 1, and further a nickel plated layer 15 with a thickness of about 2-5 µm is provided on the surface of this copper plated layer 3. Further, in the process of forming the gold plate layer on the surface of the nickel plated layer 15 of the resin substrate 1, formed is a flash gold plated layer 16 with a thickness of about 0.05 µm, which contains impurities such as cobalt and is easily joined with the nickel plated layer 15. These plated layers, i.e. copper plated layer 3, nickel plated layer 15, and flash gold plated layer 16, construct bed plated layer 17.

Next, a gold plated layer 8 with a thickness of about 0.3-0.7 µm having excellent conductivity is formed on the bed plated layer 17 in order to implement wire bonding. In this manner, in BGA 13, the metal layer of connection electrodes 6 on the IC chip mounting side and the metal layer of pad electrodes 7 on the side on which solder bumps are formed have a four-layer construction consisting of bed plated layer 17 and gold plated layer 8. In the case where no through-holes 2 are formed in resin substrate 1, the copper plated layer 3 may be omitted.

This conventional BGA, however, has the following problems.

The BGA 13 has four layers, consisting of copper plated layer 3, nickel plated layer 15, flash gold plated layer 16, and gold plated layer 8, on the surfaces of connection electrodes 6 connected to bonding wire 10 and pad electrodes 7 forming solder bumps 12.

On the other hand, solder bumps 12 for joining to mother board, not shown in the drawings, are formed by charging solder balls to pad electrodes 7, on which solder bumps 12 are to be formed, and by heating in a furnace. Further, heating is required also for joining the BGA 13 to the patterns on the mother board side via solder bumps 12.

Because of the thermal hysteresis to which the BGA 13 is subjected for forming solder bumps 12 on the lower side of resin substrate 1 and for joining solder bumps 12 to the mother board, intermetallic compound 20 consisting of gold and tin is formed in the interface of solder bumps 12 and gold plated layer 8 of resin substrate 1, thereby reducing adhesion strength between pad electrodes 7 and solder bumps 12. This weakens the anti-peeling strength of solder bumps 12 and interferes with the electrical joining, which results in inadequate conductivity to the mother board.

The semiconductor device with solder bumps of the present invention has been completed with an object of increasing adhesion strength of the solder bumps in order to remarkably improve the reliability.

The semiconductor device with solder bumps of the present invention is characterized by the features as set out in claim 1.

This structure prevents reduction in the adhesion strength between the pad electrodes in the printed resin substrate and the solder bumps, even if these are subjected to heating operations two times when the solder bumps are joined to the mother board. The anti-peeling strength of the solder bumps is thus sufficiently large for the semiconductor device with solder bumps to be highly reliable.

The process for the manufacture of semiconductor device with solder bumps of the present invention is characterized by comprising,
a patterning step comprising forming connection electrodes for IC chips on the upper side of a resin substrate of which both the upper and lower sides are laminated by copper foil, and forming pad electrodes on the lower side of said resin substrate,
a resist step comprising forming open spaces of a resist pattern on said connection electrodes and pad electrodes,
a first plating step comprising forming a part or whole of bed plated layers for gold plating on electrodes exposed in said open spaces of said resist pattern,
a resist masking step comprising forming a mask on said pad electrodes on the lower side of the resin substrate for preventing formation of a gold plated layer, and
a second plating step comprising forming the remaining bed plated layers and a gold plated layer or, solely, a gold plated layer, on said bed plated layer formed on said connection electrodes.

This process makes it possible to use the bed plated layers, such as copper plated layer, nickel plated layer, and flash gold plated layer, which are formed concurrently in the course of forming multi-plated-layers of gold on IC chip connection electrodes, as they are without an additional plating step, as a metal plated layer having affinity with solder to be formed on the pad electrodes. Thus, the process provides a remarkable advantage to actual manufacturing.

Embodiments of the present invention will now be described by way of example.
Figures 1(a) to 1(f) are sectional views of the substrate in each step of manufacturing BGA of the first embodiment of the present invention.
Figure 2 is a process scheme showing manufacturing steps of the semiconductor device with solder bumps of the first embodiment of the present invention.
Figures 3(a) and 3(b) are enlarged sectional views of a main portion, showing plated layers of BGA substrate manufactured in the process of the first embodiment of the present invention.
Figures 4(a) to 4(f) are sectional views of the substrate in each step of manufacturing BGA of the second embodiment of the present invention.
Figures 5(a) and 5(b) are enlarged sectional views of a main portion, showing metal plated layers of BGA substrate manufactured by the process shown in Figures 4(a) to 4(f).
Figures 6(a) to 6(f) are sectional views of the substrate in each step of manufacturing BGA of the third embodiment of the present invention.
Figures 7(a) and 7(b) are enlarged sectional views of a main portion, showing metal plated layers of BGA substrate manufactured by the process shown in Figures 6(a) to 6(f).
Figures 8(a) to 8(g) are sectional views of the substrate in each step of manufacturing BGA of the fourth embodiment of the present invention.
Figure 9 is an enlarged sectional view of a main portion, showing metal plated layers of BGA substrate of the fifth embodiments of the present invention.
Figures 10(a) to 10(d) are sectional views of the substrate in each step of manufacturing a conventional BGA.
Figure 11 is an overall sectional view of a conventional BGA.
Figure 12 is an enlarged sectional view of the main portion along line X-X of Figure 11.

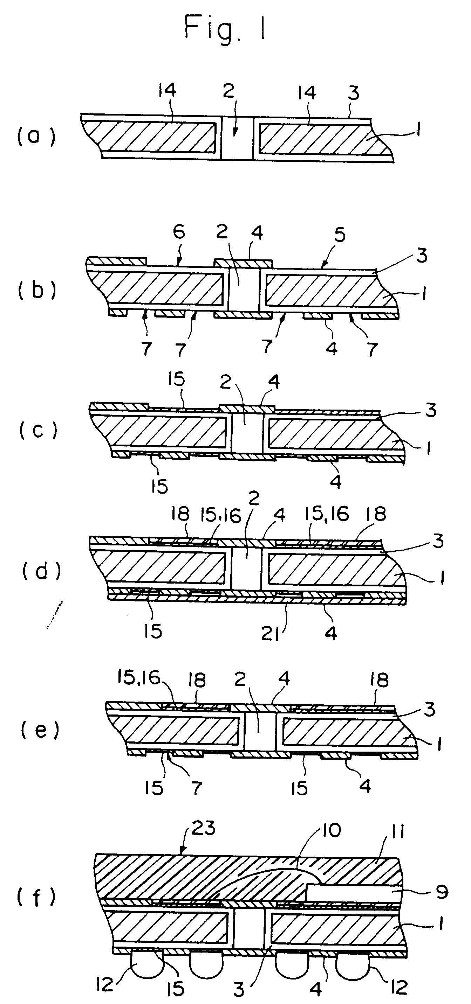

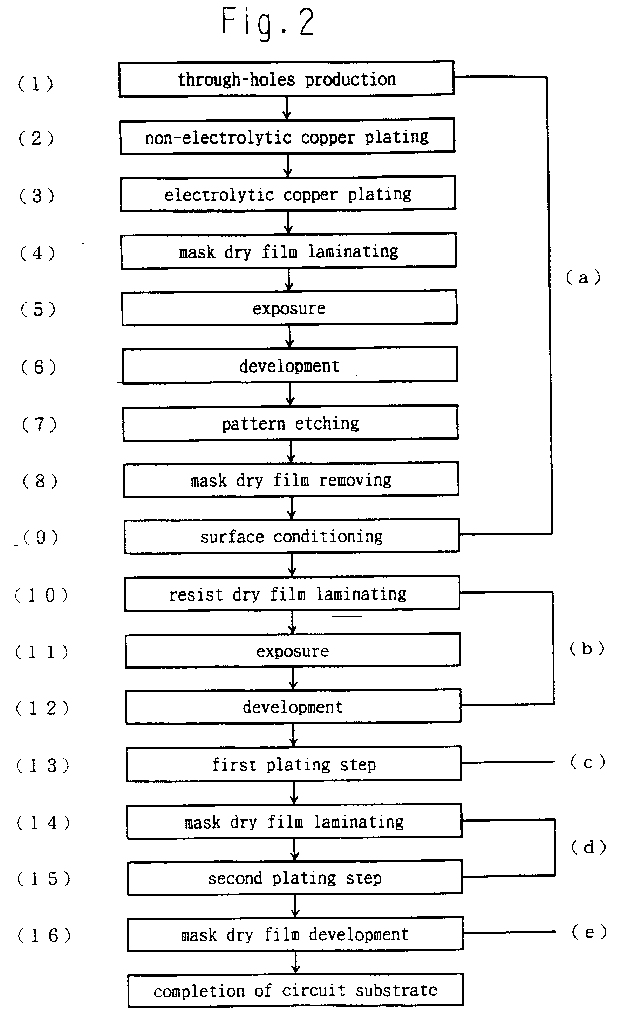

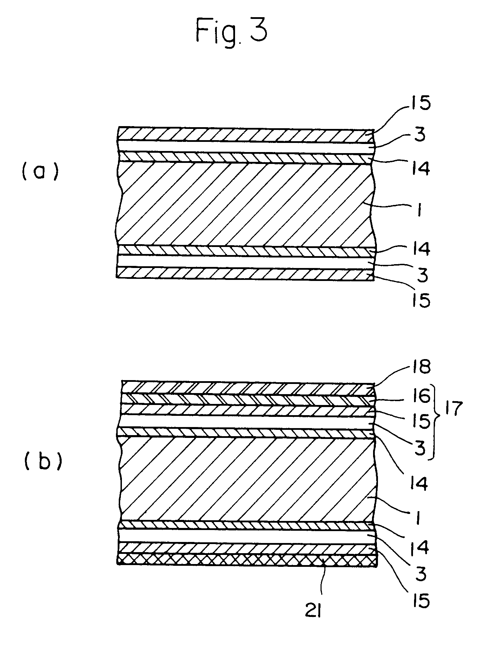

Figures 1-3 show a first embodiment of the semiconductor device with solder bumps of the present invention, and a process for manufacturing this device, in which Figures 1(a) to 1(f) are sectional views of the substrate in each step of manufacturing BGA, Figure 2 is a process scheme illustrating manufacturing steps of the printed resin substrate shown in Figure 1(a) to 1(f), and Figures 3(a) and 3(b) are enlarged sectional views of a main portion, showing plated layers on the printed resin substrate of BGA as manufactured in this process. Symbols for the parts which correspond to those used in the conventional technology are designated by the same symbols as in the conventional technology all through these Figures.

Figures 1(a) and 1(b) show the same conditions as those of Figures 10(a) and 10(b) illustrated above in connection with a conventional technology. The printed resin substrate 1 has a thin copper foil (not shown in the Figures) laminated on both sides. After drilling through-holes 2, a copper plated layer 3 is provided all over the surfaces by electrolytic and non-electrolytic copper plating. After forming a pattern mask by laminating a plated resist, and irradiating and developing the resist, pattern etching is performed using CuCl₂ + H₂O₂ which is a common circuit board etching solution. In this manner, a die pattern 5 for IC chips 9 and connection electrodes 6 for wire-bonding is formed on the upper side of the substrate and pad electrodes 7 are for forming solder bumps is formed on the lower side.

The connection electrodes 6 and pad electrodes 7 are joined via through-holes 2.

Next, in the resist dry film laminating step, a dry film 4 is formed by laminating a plated resist on copper plated layer 3 on the both sides of the printed resin substrate 1, and irradiating and developing the resist, and opening spaces of resist pattern are formed on die pattern 5 and connection electrodes 7 on the upper side and on pad electrodes 7 on the lower side.

Figure 1(c) is a sectional view of the substrate during the first plating step. This first plating step is a step for forming a part or whole of bed plated layers. In this embodiment, nickel plated layer 15 is formed as a part of the bed plated layers.

Figure 3(a) is an enlarged sectional view, showing main portion of metal plated layer in the substrate of Figure 1(c). A copper foil layer 14 with a thickness of about 18 µm is formed on the both sides of printed resin substrate 1, and copper plated layer 3 is formed electrolytically or non-electrolytically over the whole surface of this copper foil layer 14. Further, nickel plated layer 15 with a thickness of about 2-5 µm is provided on the surface of this copper plated layer 3 in the nickel plating step.

Figure 1(d) shows the sectional view of the substrate during the second plating step, wherein a gold plated layer is formed on connection electrodes 6 on the upper side of the printed resin substrate 1. Prior to the second plating step, a mask dry film 21 is laminated all over the lower side in the mask dry film laminating step, in order to prevent a gold plated layer from being formed on pad electrodes 7 on the lower side of the substrate.

Next, in the second plating step, a flash gold plated layer 16 (see Figure 3) with a thickness of about 0.05 µm, which is the remaining bed plating layer, containing impurities such as cobalt and easily joined with the nickel plated layer 15, is formed, and, on this flash gold plated layer 16, a gold plated layer 18 with a thickness of about 0.3-0.7 µm is further formed. As a result, as shown in Figure 3(b), the metal layers on the IC chip mounting side consist of multi-layered bed plated layer 17, which is made from copper plated layer 3, nickel plated layer 15 and flash gold plated layer 16, and a gold plated layer 18 for implementing wire bonding (Figure 3(b) is an enlarged sectional view of a main portion showing metal plated layers of the substrate in Figure 1(d)).

Figure 1(e) shows a sectional view of the substrate during the mask dry film development step, wherein the mask dry film 21 on the lower side of the printed resin substrate 1 is removed, and the substrate is completed.

In this manner, gold plated layer 18 which is suitable for wire bonding is formed on the surfaces of die pattern 5 and connection electrodes 6 of the substrate after removal of mask dry film 21, and a two-layered plated metal, consisting of copper plated layer 3 and nickel plated layer 15, is formed on pad electrodes 7 on the lower side of the substrate. As a result, nickel plated layer 15 having excellent affinity with solder is formed on the surface of pad electrodes 7.

Next, after mounting IC chip 9 on die pattern 5 on the upper side of the printed resin substrate 1 and after bonding these by wire-bonding, the IC chip 9 and the bonding wire 10 are sealed with thermoset sealing resin 11 by transfer molding, thereby ensuring light-shielding and protection of IC chip 9.

Further, solder balls are fed to a plural number of pad electrodes 7 which have nickel plated layer 15 having excellent affinity with solder, on the lower surface side of printed resin substrate 1. The substrate is then heated in a furnace to form solder bumps 12 (Figure 1(f)) for joining to the mother board, not shown in the drawings.

BGA 23 is completed in this manner.

In Figure 2, which shows a process for manufacturing the printed resin substrate in detail, (1) indicates a through-holes production step; (2), a non-electrolytic copper plating step; (3), an electrolytic copper plating step; (4), a mask dry film laminating step; (5), an exposure step; (6) a development step; (7), a pattern etching step, wherein the pattern etching is performed using CuCl₂ + H₂O₂ as an etching solution; (8), a mask dry film removing step; (9), a surface conditioning step; (10), a resist dry film laminating step; (11), an exposure step; (12) a development step; (13), a first plating step; (14), a mask dry film laminating step; (15), a second plating step; and (16), a mask dry film development step.

In the relationships between the steps of Figure 2 and Figures 1(a) to 1(f), as shown in Figure 2, steps (1)-(9) correspond to Figure 1(a); steps (10)-(12), correspond to Figure 1(b); step (13), to Figure 1(c); steps (14) and (15), to Figure 1(d); and step (16), to Figure 1(e).

The BGA 23 as completed is reheated for joining to the pattern on the mother board side via solder bumps 12. BGA 23 as completed by the process mentioned above is also heated in the step of forming solder bumps 12 on the lower side of the printed resin substrate 1. Even though the BGA of the present invention is subjected to the thermal hysteresis by heating twice as mentioned above, there is no possibility of intermetallic formation in the interface of solder bumps 12, because of absence of a gold plated layer on pad electrodes 7 on printed resin substrate 1.

Therefore, there are no risks for the adhesion strength between the pad electrodes 7 and the solder bumps to be reduced, providing a strong anti-peeling strength. A highly reliable semiconductor device with solder bumps is thus provided.

According to the process of the present invention, there are formed a multi-plated-layer of gold containing a bed plated layer on connection electrodes 6 and a part of the bed plating layer on pad electrodes 7 by providing a resist mask on pad electrodes 7 in the course of a series of plating operations where multi-layer plating of gold containing the bed plated layer is formed on the electrodes on printed resin substrate 1.

If an electrode film is formed in this manner, a metal plated layer (nickel plated layer) having excellent affinity with solder bumps 12 to be formed on pad electrodes 7 can be produced in the course of the step where the multi-plated layer of gold is formed on said connection electrodes 6, without requiring a special plating step for providing a metal plated layer having excellent affinity with solder bumps 12 on pad electrodes 7. This brings about a great advantage to the manufacturing process.

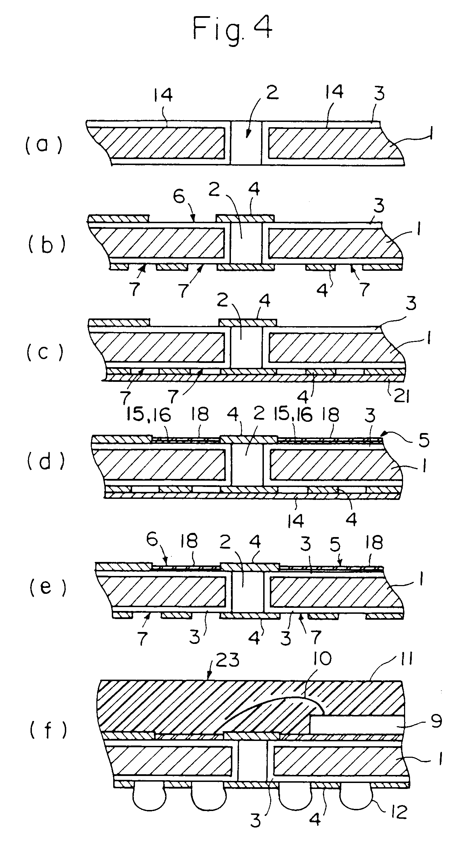

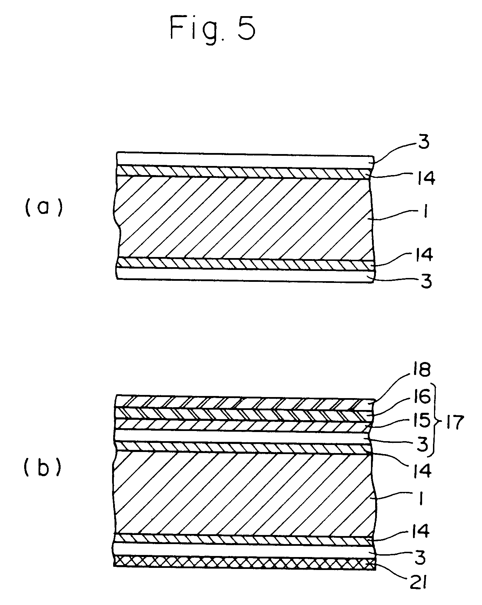

Figures 4(a) to 4(f) are sectional views of the substrate in each step of manufacturing BGA of the second embodiment of the present invention, and Figures 5(a) and 5(b) are enlarged sectional views of a main portion, showing metal plated layers of BGA substrate manufactured by this process.

In Figures 4 and Figures 5, Figures 4(a) and 4(b) are the same as Figures 1(a) and 1(b) of the first embodiment, and thus the descriptions on these Figures are omitted. Figure 5(a) shows a bed plated layer, and on both sides of the printed resin substrate 1 formed are a copper foil layer 14 and, on this copper foil layer 14, copper plated layer 3 as a bed plated layer to be formed in the first plating step.

Figure 4(c) shows a sectional view of the substrate during the mask dry film laminating step. In this mask dry film laminating step, the whole lower side surface is masked with mask dry film 21 in order to preclude formation of a gold plated layer on pad electrodes 7 on the lower side, when the gold plated layer is formed on connection electrodes 6 on the upper side of printed resin substrate 1.

Figure 4(d) shows a sectional view of the substrate during the second plating step. In the second plating step, after forming the remaining bed plated layer on the surface of copper plated layer 3 on the upper side of printed resin substrate 1, while masking the whole lower side surface with mask dry film 21, a gold plated layer is formed on connection electrodes 6. In this second plating step, as shown in Figure 5(b), nickel plated layer 15 and flash gold plated layer 16, which are the remaining bed plated layer, are formed, and, on the flash gold plated layer 16, gold plated layer 18 is further formed.

As a result, the metal layers on the IC chip mounting side consist of bed plated layer 17 of a three-layer structure, which consists of copper plated layer 3, nickel plated layer 15 and flash gold plated layer 16, and a gold plated layer 18 for implementing wire bonding, whereas only copper plated layer 3 is formed on pad electrodes 7 on the lower side.

Figure 4(e) shows a sectional view of the substrate during development of the mask dry film. In the mask dry film development step, an etching treatment using an etching solution, for example, of sodium bicarbonate, is implemented in order to remove the mask dry film 21 which is produced on the lower side of printed resin substrate 1. Only the masked dry film 21 is released by this treatment, leaving the dry film 4 which have been exposed to lights, and copper plated layer 3 is exposed on pad electrodes 7 on the lower side. The substrate is completed in this manner.

As a result, gold plated layer 18 suitable for wire bonding is formed on die pattern 5 and connection electrodes 6 in the substrate as completed, and copper plated layer 3 having excellent affinity with solder is formed on pad electrodes 7 on the lower side.

Next, after mounting IC chip 9 on die pattern 5 on the upper side of the printed resin substrate 1 and after bonding these by wire-bonding 10, the IC chip 9 and the bonding wire 10 are sealed with thermoset sealing resin 11 by transfer molding. Further, solder balls are fed to a plural number of pad electrodes 7, which have copper plated layer 3 having excellent affinity with solder, on the lower surface side of printed resin substrate 1. The substrate is then heated in a furnace to form solder bumps 12 (Figure 4(f)) for joining to the mother board, not shown in the drawings.

BGA 23 is completed in this manner.

Because the BGA as completed in this manner has no risks of intermetallic formation in the interface of pad electrodes 7 and solder bumps 12 on the printed resin substrate 1, in the same manner as the BGA of the first embodiment, there are no risks for the adhesion strength between the pad electrodes 7 and the solder bumps 12 to be reduced. A highly reliable semiconductor device with solder bumps with a strong anti-peeling strength is thus provided.

If an electrode film is formed in this manner, a metal plated layer (copper plated layer) having excellent affinity with solder bumps to be formed on pad electrodes can be produced in the course of the step where the multi-plated layer of metal is formed on the electrodes, without requiring a special plating step for providing a metal plated layer having excellent affinity with solder bumps on pad electrodes. This brings about a great advantage to the manufacturing process.

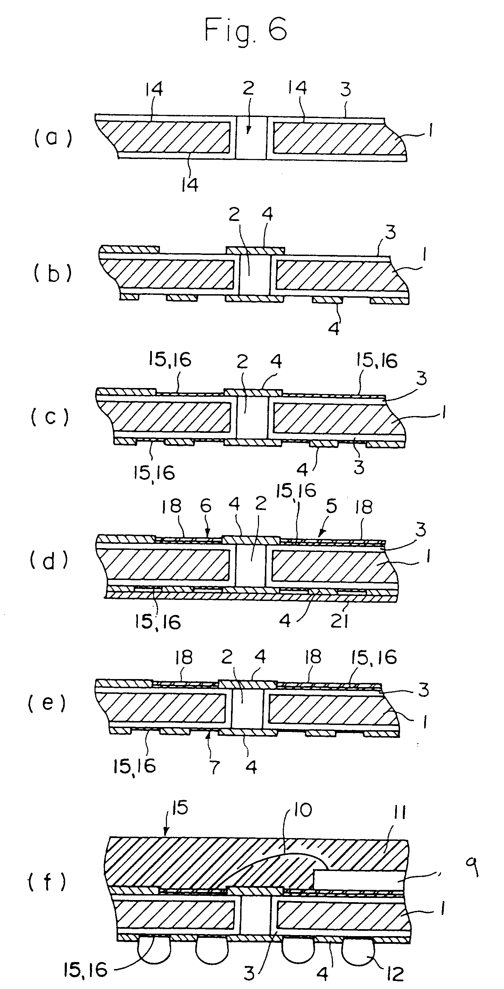

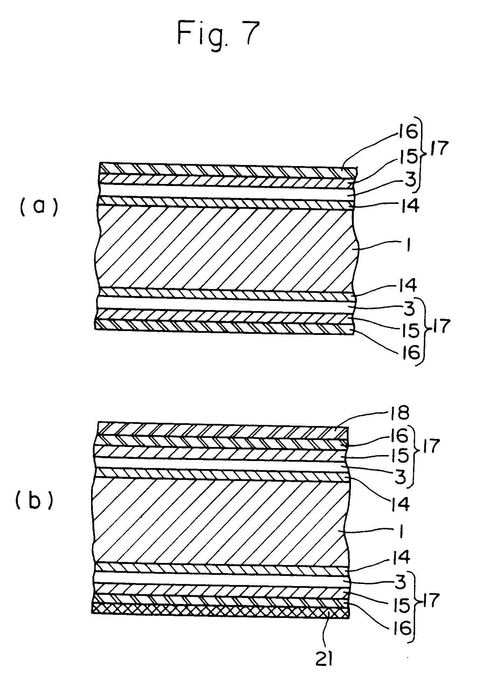

Next, Figures 6(a) to 6(f) are sectional views of the substrate in the process of manufacturing BGA of the third embodiment of the present invention, and Figures 7(a) and 7(b) are enlarged sectional views of the main portion, showing metal plated layers of BGA substrate manufactured by this process.

In Figures 6 and 7, Figures 6(a) and 6(b) are the same as Figures 1(a) and 1(b) of the first embodiment, and thus the descriptions on these Figures are omitted. Figure 7(a) shows a bed plated layer, and on both sides of the printed resin substrate 1 formed are copper foil layer 14 and, on this copper foil layer 14, copper plated layer 3 as one of the bed plated layers to be formed in the first plating step.

Figure 6(c) shows a sectional view of the substrate during the first plating step. In this first plating step, nickel plated layer 15 is formed as the remaining bed plated layer on copper plated layer 3, and further on this nickel plated layer 15 a flash gold plated layer 16 with a thickness of about 0.05 µm and containing impurities such as cobalt which is easily joined with the nickel plated layer 15.

Figure 6(d) shows a sectional view of the substrate during the second plating step. In the second plating step, a gold plated layer is formed on connection electrodes 6 on the upper side of printed resin substrate 1. Prior to the second plating step, a mask dry film 21 is provided all over the lower side in order to prevent a gold plated layer from being formed on pad electrodes 7 on the lower side of the substrate and to form a gold plated layer only on the bed plated layer 17 which has been formed on the upper side. Because only the gold plated layer 18 is formed on said flash gold plated layer 16 in the second plating step, the metal layers on the IC chip mounting side consist of bed plated layer 17 of a three-layer structure, which consists of copper plated layer 3, nickel plated layer 15 and flash gold plated layer 16, and a gold plated layer 18 for implementing wire bonding.

As a result, gold plated layer 18 suitable for wire bonding is formed on die pattern 5 and connection electrodes 6 in the printed resin substrate 1 of this embodiment as completed, and on pad electrodes on the lower side formed are metal plated layers (bed plated layer 17) of a three-layer structure, which consist of copper plated layer 3, nickel plated layer 15, and flash gold plated layer 16.

Figure 6(e) shows a sectional view of the substrate during development of the mask dry film. In the mask dry film development step, the masked dry film 21 provided on the lower side of printed resin substrate 1 is removed in the same manner as in the above-described first embodiment in reference to Figure 1(e). The printed resin substrate 1 is completed at this step.

After mounting IC chip 9 on die pattern 5 on the upper side of the printed resin substrate 1 and after bonding these by wire-bonding 10, the IC chip 9 and the bonding wire 10 are sealed with thermoset sealing resin 11 by transfer molding. Further, solder balls are fed to a plural number of pad electrodes 7 on the lower side of printed resin substrate 1. The substrate is then heated in a furnace to form solder bumps 12 (Figure 6(f)).

BGA 23 is completed in this manner.

In the BGA as completed in this manner, there are no risks for the adhesion strength between the printed resin substrate 1 and the solder bumps 12 to be reduced, in spite of the thermal hysteresis during the formation of solder bumps 12 and the operation for joining the solder bumps 12 to the mother board, because in the solder bump 12 and pad electrodes 7 on the lower side of the printed resin substrate 1 the nickel plated layer 15 and solder are joined together via flash gold plated layer 16. A highly reliable semiconductor device with solder bumps exhibiting a strong anti-peeling strength is thus provided.

Specifically, the metal plated layers on these pad electrodes 7 comprise a thin flash gold plated layer 16 formed on nickel plated layer 15 having excellent affinity with solder bumps. Therefore, when the solder balls are fed to the pad electrodes 7 and treated with heat, even though a portion of melted solder reacts and fused with flash gold plated layer 16, a major portion of the solder goes through the flash gold plated layer 16 and strongly fuses to nickel plated layer 15 underneath, because this flash gold plated layer 16 is an extremely thin layer.

In addition, because the surface of nickel plated layer 15 is kept neat with no oxidation due to the flash gold plated layer 16, the bonding conditions with solder are excellent. In other words, because this metal plated layer formed on pad electrode 7 has flash gold plated layer 16, acting as an oxidation preventing film against nickel plated layer 15, formed on the surface of nickel plated layer 15 which has excellent affinity with solder, the needs for removing oxidized films are eliminated.

Because in the metal plated layer on pad electrodes 7 in the BGA of the third embodiment nickel plated layer 15 or copper plated layer 3, both readily oxidized, are not exposed, there are no risks for pad electrodes 7 to be oxidized during mounting operation of IC. Because of this, no step for removal of oxidized films required. The process is thus extremely advantageous.

Although an intermetallic compound may be produced by flash gold plated layer 16 on pad electrode 7 and solder, it is possible to make the amount of the intermetallic compound produced so small that there are no substantial effects on the bonding force between pad electrode 7 and solder bump 12, by fabricating flash gold plated layer 16 thin enough.

It is therefore desirable to make the thickness of flash gold plated layer 16 of pad electrode 7 as small as required for it to function as an anti-oxidation film. Specifically, a thickness of 0.1 µm or smaller is sufficient for maintaining adequate bonding strength between pad electrode 7 and solder bump 12.

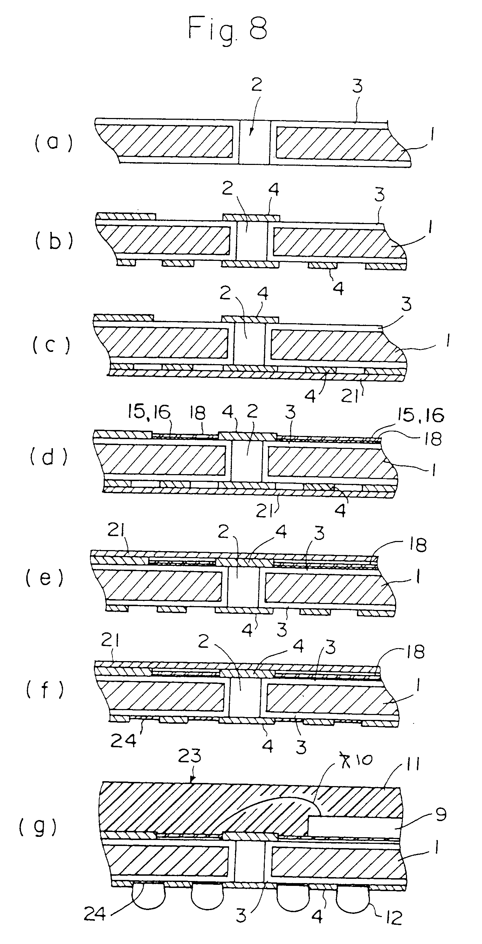

Figures 8(a) to 8(g) are sectional views of the BGA substrate in each step of manufacturing BGA of the fourth embodiment of the present invention. Differently from the first to third embodiments, in this fourth embodiment a plated layer of an optional metal exhibiting excellent affinity with solder is produced on pad electrodes.

In Figures 8(a) to 8(d), in the same manner as in Figures 4(a) to 4(d) of the second embodiment, copper plated layer 3 and dry film 4 which are part of the bed plated layer are formed. Then, the whole lower side surface is masked with mask dry film 21 in order to preclude formation of a gold plated layer on pad electrodes 7 on the lower side, when the gold plated layer is formed on connection electrodes 6 on the upper side of printed resin substrate 1. Further, nickel plated layer 15, flash gold plated layer 16, and gold plated layer 18, which constitute the bed plated layer, are formed on connection electrodes 6 on the upper side of printed resin substrate 1.

Figure 8(e) shows a sectional view of the substrate during lamination of the mask dry film. In the mask dry film lamination step, after removing the masked dry film 21 laminated on the lower side, gold plated layer 18 on connection electrodes 6 formed on the upper side is masked with mask dry film 21, when a plated layer of a metal having excellent affinity with solder is formed on pad electrodes 7 on the lower side.

Figure 8(f) shows a sectional view of BGA substrate during the plating step. This step consists of forming silver plated layer 24, as an optional metal plated layer having excellent affinity with solder, on pad electrodes 7 on the lower side. The circuit substrate is completed by this step.

After removing mask dry film 21 on the upper side and after mounting IC chip 9 on die pattern 5 on the upper side of the printed resin substrate 1 and bonding these by wire-bonding 10, the IC chip 9 and the bonding wire 10 are sealed with thermoset sealing resin 11 by transfer molding.

Further, solder balls are fed to a plural number of pad electrodes 7 having silver plated layer 24, which has good affinity with solder, on the lower side of printed resin substrate 1. The substrate is then heated in a furnace to form solder bumps 12 (Figure 8(g)) for connection to the mother board which is not shown in the drawings.

BGA 23 is completed in this manner.

In the BGA as completed in this manner, there are no risks for the adhesion strength between the printed resin substrate 1 and the solder bumps 12 to be reduced, in spite of the thermal hysteresis during the formation of solder bumps 12 and the operation for joining the solder bumps 12 to the mother board, because no intermetallic substance is produced in the interface of silver plated layer 24 and solder bumps 12. A highly reliable semiconductor device with solder bumps exhibiting a strong anti-peeling strength is thus provided.

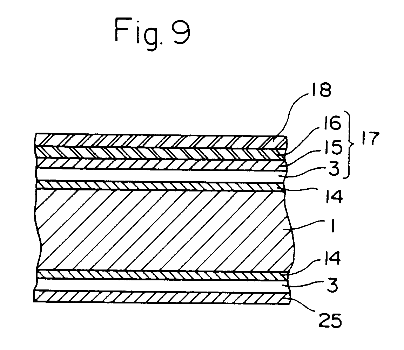

Figure 9 is an enlarged sectional view of a main portion, showing metal plated layers in the printed resin substrate of the fifth embodiments of the present invention. In the same manner as in the third embodiment, this embodiment has a construction in which an anti-oxidation film is formed on the metal plated layers of pad electrodes 7. Specifically, because copper plated layer 3 exhibiting good affinity with solder is exposed on pad electrodes 7 on the lower side of printed substrate 1 after releasing mask dry film 21, a thin film of hard flux (hard oil film) 25 used for soldering is provided as an anti-oxidation film for preventing the copper plated layer 3 from being oxidized.

The anti-oxidation film is not limited to the above-mentioned flash gold plated layer or hard flux. It is possible to use any materials which can prevent oxidation of plated metals exhibiting excellent affinity with solder and which does not interfere with the bonding strength between solder and pad electrodes.

Japanese Patent Application No. 290327/1993 filed on November 19, 1993 and No. 55806/1994 filed on March 25, 1994 are herein incorporated as references.

## Claims

1. A semiconductor device with solder bumps having a resin substrate of which both the upper and lower sides are laminated by a copper foil, which is provided with connection electrodes for IC chips and pad electrodes for external connection, said pad electrodes are provided with solder bumps, wherein a gold plated layer is formed on said connection electrodes and a plated layer of a metal having affinity with solder on said pad electrodes, characterised in that said gold plated layer on said connection electrodes is part of a multi-plated-layer which also includes a bed plated layer under said gold plated layer and wherein the bed plated layer is the same as at least part of said plated layer on the pad electrodes; said connection electrodes being provided on the upper side of the device and the pad electrodes or the lower side, joined together via a through hole.

2. The semiconductor device with solder bumps as claimed in claim 1, wherein said bed plated layer formed on the connection and pad electrodes is a copper plated layer.

3. The semiconductor device with solder bumps as claimed in claim 1, wherein said bed plated layer formed on the connection and pad electrodes consists of a copper plated layer and a nickel plated layer formed on the copper plated layer.

4. The semiconductor device with solder bumps as claimed in claim 1, wherein said bed plated layer formed on the connection and pad electrodes consists of a copper plated layer and a nickel plated layer, and a flash gold plated layer formed on the copper plated layer and the nickel plated layer.

5. The semiconductor device with solder bumps as claimed in any of the above claims, wherein said metal plated layer formed on the pad electrodes includes a plated layer of a metal selected from copper, nickel, and silver.

6. The semiconductor device with solder bumps as claimed in any of the above claims, further providing an anti-oxidation film on said plated layer of a metal having affinity with solder.

7. The semiconductor device with solder bumps as claimed in claim 6, wherein said anti-oxidation film is a hard oil film.

8. The semiconductor device with solder bumps as claimed in claim 6, wherein said anti-oxidation film is a thin gold plated layer.

9. The semiconductor device with solder bumps as claimed in claim 8, wherein said thin gold plated layer for preventing oxidation has a thickness smaller than the thickness of said gold plated layer on said connection electrodes.

10. The semiconductor device with solder bumps as claimed in claim 9, wherein the thickness of said gold plated layer for preventing oxidation is 0.1 µm or less.

11. A process for manufacturing a semiconductor device with solder bumps having a resin substrate of which both the upper and lower sides are laminated by a copper foil, the substrate being provided with connection electrodes for IC chips on the upper side and pad electrodes for external connection on the lower side, joined with each other via through-holes, said pad electrodes being provided with solder bumps, characterized by comprising,
a patterning step comprising forming connection electrodes for IC chips on the upper side of said resin substrate and forming pad electrodes on the lower side of said resin substrate,
a resist step comprising forming open spaces of a resist pattern on said connection electrodes and pad electrodes,
a first plating step comprising forming a part or whole of a bed plated layer on electrodes exposed in said open spaces of said resist pattern,
a resist masking step comprising forming a mask on said pad electrodes on the lower side of the resin substrate for preventing formation of a gold plated layer, and
a second plating step comprising forming a remaining bed plated layer and a gold plated layer or, solely, a gold plated layer, on said bed plated layer formed on said connection electrodes.

12. The process for manufacturing a semiconductor device with solder bumps as claimed in claim 11, wherein said bed plated layer in said first plating step is a copper plated layer, and the metal plating in said second plating step comprises forming a multi-plated layer of a nickel plated layer, a flash gold plated layer, and a gold plated layer.

13. The process for manufacturing a semiconductor device with solder bumps as claimed in claim 11, wherein plating of said bed plated layer in said first plating step comprises forming a multi-plated layer consisting of a copper plated layer and a nickel plated layer, and plating of said second plating step comprises forming a multi-plated layer consisting of a flash gold plated layer and a gold plated layer.

14. The process for manufacturing a semiconductor device with solder bumps as claimed in claim 11, wherein plating of said bed plated layer in said first plating step comprises forming a multi-plated layer consisting of a copper plated layer, a nickel plated layer, and a flash gold plated layer, and plating of said second plating step comprises forming a gold plated layer.

15. A process for manufacturing a semiconductor device with solder bumps according to claim 11, further including
a step for removing said resist mask from the lower side of said resin substrate,
a resist masking step comprising forming a resist mask on the upper side of said resin substrate, and a step for forming a silver plated layer on said pad electrodes on lower side of said resin substrate.

16. A process for manufacturing a semiconductor device with solder bumps according to claim 11, further including
a step for removing said resist mask from the lower side of said resin substrate, and
a step for forming an anti-oxidation film on said pad electrodes on the lower side of said resin substrate.

## Patentansprüche

1. Halbleitervorrichtung mit Lötstellen, die ein Harzsubstrat aufweist, bei dem sowohl auf die Ober- als auch die Unterseite eine Kupferfolie auflaminiert ist, und die mit Anschlusselektroden für IC-Chips und Lötflächenelektroden für den externen Anschluss versehen ist, wobei die Lötflächenelektroden mit Lötstellen versehen sind, worin eine goldplattierte Schicht auf den Anschlusselektroden und eine plattierte Schicht aus einem Metall mit Affinität für Lötmittel auf den Löststellenelektroden ausgebildet ist, dadurch gekennzeichnet, dass die goldplattierte Schicht auf den Anschlusselektroden Teil einer multiplattierten Schicht ist, die auch eine bettplattierte Schicht unter der goldplattierten Schicht aufweist und worin die bettplattierte Schicht die selbe wie zumindest ein Teil der plattierten Schicht auf den Lötflächenelektroden ist, wobei die Anschlusselektroden an der Oberseite der Vorrichtung und die Lötflächenelektroden an deren Unterseite vorgesehen sind und sie über ein Durchgangsloch miteinander verbunden sind.

2. Halbleitervorrichtung mit Lötstellen nach Anspruch 1, worin die auf den Anschluss- und den Lötflächenelektroden ausgebildete bettplattierte Schicht eine kupferplattierte Schicht ist.

3. Halbleitervorrichtung mit Lötstellen nach Anspruch 1, worin die auf den Anschluss- und den Lötflächenelektroden ausgebildete bettplattierte Schicht aus einer kupferplattierten Schicht und einer auf der kupferplattierten Schicht ausgebildeten nickelplattierten Schicht besteht.

4. Halbleitervorrichtung mit Lötstellen nach Anspruch 1, worin die auf den Anschluss- und den Lötflächenelektroden ausgebildete bettplattierte Schicht aus einer kupferplattierten Schicht und einer nickelplattierten Schicht sowie einer auf der kupferplattierten Schicht und der nickelplattierten Schicht ausgebildeten anschlaggalvanisierten Goldschicht besteht.

5. Halbleitervorrichtung mit Lötstellen nach einem der vorangegangenen Ansprüche, worin die auf den Lötflächenelektroden ausgebildete metallplattierte Schicht eine plattierte Schicht aus einem Metall umfasst, das aus Kupfer, Nickel und Silber ausgewählt ist.

6. Halbleitervorrichtung mit Lötstellen nach einem der vorangegangenen Ansprüche, bei der auf der plattierten Schicht aus einem Metall mit Affinität für Lötmittel weiters ein oxidationshemmender Film vorgesehen ist.

7. Halbleitervorrichtung mit Lötstellen nach Anspruch 6, worin der oxidationshemmende Film ein harter Ölfilm ist.

8. Halbleitervorrichtung mit Lötstellen nach Anspruch 6, worin der oxidationshemmende Film eine dünne goldplattierte Schicht ist.

9. Halbleitervorrichtung mit Lötstellen nach Anspruch 8, worin die dünne goldplattierte Schicht zur Verhinderung von Oxidation eine Dicke aufweist, die geringer als die Dicke der goldplattierten Schicht auf den Anschlusselektroden ist.

10. Halbleitervorrichtung mit Lötstellen nach Anspruch 9, worin die Dicke der goldplattierten Schicht zur Verhinderung von Oxidation 0,1 µm oder weniger beträgt.

11. Verfahren zur Herstellung einer Halbleitervorrichtung mit Lötstellen, die ein Harzsubstrat aufweist, bei dem sowohl auf die Ober- als auch die Unterseite eine Kupferfolie auflaminiert ist, wobei das Substrat mit Anschlusselektroden für IC-Chips auf der Oberseite und Lötflächenelektroden für den externen Anschluss an der Unterseite versehen ist, die über Durchgangslöcher miteinander verbunden sind, wobei die Lötflächenelektroden mit Lötstellen versehen sind, dadurch gekennzeichnet, dass es umfasst:
einen Musterungsschritt, der das Ausbilden von Anschlusselektroden für IC-Chips auf der Oberseite des Harzsubstrats und das Ausbilden von Lötflächenelektroden auf der Unterseite des Harzsubstrats umfasst,
einen Resist-Schritt, der das Ausbilden offener Flächen in einem Resistmuster auf den Anschlusselektroden und den Lötflächenelektroden umfasst;
einen ersten Plattierungsschritt, der das Ausbilden eines Teils einer oder einer gesamten bettplattierten Schicht auf Elektroden umfasst, die in den offenen Flächen des Resistmusters freiliegen,
einen Resistmaskierungsschritt, der das Ausbilden einer Maske auf den Lötflächenelektroden an der Unterseite des Harzsubstrats umfasst, um die Bildung einer goldplattierten Schicht zu verhindern, sowie
einen zweiten Plattierungsschritt, der das Ausbilden einer verbleibenden bettplattieren Schicht und einer goldplattierten Schicht oder einer goldplattierten Schicht allein auf der auf den Anschlusselektroden ausgebildeten bettplattierten Schicht umfasst.

12. Verfahren zur Herstellung einer Halbleitervorrichtung mit Lötstellen nach Anspruch 11, worin die bettplattierte Schicht im ersten Plattierungsschritt eine kupferplattierte Schicht ist und die Metallplattierung im zweiten Plattierungsschritt das Ausbilden einer multiplattierten Schicht aus einer nickelplattierten Schicht, einer anschlaggalvanisierten Goldschicht und einer goldplattierten Schicht umfasst.

13. Verfahren zur Herstellung einer Halbleitervorrichtung mit Lötstellen nach Anspruch 11, worin das Plattieren der bettplattierten Schicht im ersten Plattierungsschritt das Ausbilden einer multiplattierten Schicht umfasst, die aus einer kupferplattierten Schicht und einer nickelplattierten Schicht besteht, und das Plattieren des zweiten Plattierungsschritts das Ausbilden einer multiplattierten Schicht umfasst, die aus einer anschlaggalvanisierten Goldschicht und einer goldplattierten Schicht besteht.

14. Verfahren zur Herstellung einer Halbleitervorrichtung mit Lötstellen nach Anspruch 11, worin das Plattieren der bettplattierten Schicht im ersten Plattierungsschritt das Ausbilden einer multiplattierten Schicht umfasst, die aus einer kupferplattierten Schicht, einer nickelplattierten Schicht und einer anschlaggalvanisierten Goldschicht besteht, und das Plattieren des zweiten Plattierungsschritts das Ausbilden einer goldplattierten Schicht umfasst.

15. Verfahren zur Herstellung einer Halbleitervorrichtung mit Lötstellen nach Anspruch 11, weiters umfassend:
einen Schritt des Entfernens der Resistmaske von der Unterseite des Harzsubstrats, einen Resistmaskierungsschritt, der das Ausbilden einer Resistmaske auf der Oberseite des Harzsubstrats umfasst, und einen Schritt des Ausbildens einer silberplattierten Schicht auf den Lötflächenelektroden auf der Unterseite des Harzsubstrats.

16. Verfahren zur Herstellung einer Halbleitervorrichtung mit Lötstellen nach Anspruch 11, weiters umfassend:
einen Schritt des Entfernens der Resistmaske von der Unterseite des Harzsubstrats, und
einen Schritt des Ausbildens eines oxidationshemmenden Films auf den Lötflächenelektroden an der Unterseite des Harzsubstrats.

## Revendications

1. Dispositif à semiconducteur avec des bosses de soudure ayant un substrat en résine dont à la fois les côtés supérieur et inférieur sont laminés par une feuille en cuivre, qui est pourvue d'électrodes de connexion pour des puces à circuit intégré et d'électrodes de plage pour la connexion externe, lesdites électrodes de plage sont pourvues de bosses de soudure, où une couche plaquée or est formée sur lesdites électrodes de connexion et une couche plaquée en un métal ayant une affinité avec la soudure sur lesdites électrodes de plage, caractérisé en ce que ladite couche plaquée or sur lesdites électrodes de connexion fait partie d'une couche à placage multiple qui comporte également une couche plaquée de base sous ladite couche plaquée or et où la couche plaquée de base est la même qu'au moins une partie de ladite couche plaquée sur les électrodes de plage; lesdites électrodes de connexion étant prévues sur le côté supérieur du dispositif et les électrodes de plage sur le côté inférieur, en étant reliées ensemble par un trou traversant.

2. Dispositif à semiconducteur avec des bosses de soudure tel que revendiqué dans la revendication 1, dans lequel ladite couche plaquée de base formée sur les électrodes de connexion et de plage est une couche plaquée cuivre.

3. Dispositif à semiconducteur avec des bosses de soudure tel que revendiqué dans la revendication 1, dans lequel ladite couche plaquée de base formée sur les électrodes de connexion et de plage est constituée d'une couche plaquée cuivre et d'une couche plaquée nickel formée sur la couche plaquée cuivre.

4. Dispositif à semiconducteur avec des bosses de soudure tel que revendiqué dans la revendication 1, où ladite couche plaquée de base formée sur lesdites électrodes de connexion et de plage est constituée d'une couche plaquée cuivre et d'une couche plaquée nickel, et d'une couche plaquée or flash formée sur la couche plaquée cuivre et la couche plaquée nickel.

5. Dispositif à semiconducteur avec des bosses de soudure tel que revendiqué dans l'une des revendications précédentes, où ladite couche plaquée métal formée sur les électrodes de plage comporte une couche plaquée en un métal sélectionné parmi le cuivre, le nickel, et l'argent.

6. Dispositif à semiconducteur avec des bosses de soudure tel que revendiqué dans l'une des revendications précédentes, réalisant en outre un film anti-oxydation sur ladite couche plaquée en un métal ayant une affinité avec la soudure.

7. Dispositif à semiconducteur avec des bosses de soudure tel que revendiqué dans la revendication 6, où ledit film anti-oxydation est un film d'huile dure.

8. Dispositif à semiconducteur avec des bosses de soudure tel que revendiqué dans la revendication 6, dans lequel ledit film anti-oxydation est une couche mince plaquée or.

9. Dispositif à semiconducteur avec des bosses de soudure tel que revendiqué dans la revendication 8, dans lequel ladite couche mince plaquée or pour empêcher une oxydation a une épaisseur plus petite que l'épaisseur de ladite couche plaquée or sur lesdites électrodes de connexion.

10. Dispositif à semiconducteur avec des bosses de soudure tel que revendiqué dans la revendication 9, où l'épaisseur de ladite couche plaquée or pour empêcher une oxydation est de 0,1 µm ou moins.

11. Procédé de fabrication d'un dispositif à semiconducteur avec des bosses de soudure ayant un substrat en résine dont les côtés supérieur et inférieur sont laminés par une feuille en cuivre, le substrat étant pourvu d'électrodes de connexion pour des puces à circuit intégré sur le côté supérieur et d'électrodes de plage pour la connexion externe au côté inférieur, reliées les unes aux autres par des trous traversants, lesdites électrodes de plage étant pourvues de bosses de soudure, caractérisé en ce qu'il comprend:
une étape de réalisation de motif comprenant la formation des électrodes de connexion pour des puces à circuit intégré sur le côté supérieur dudit substrat en résine et la formation d'électrodes de plage sur le côté inférieur dudit substrat en résine,
une étape de résist comprenant la formation d'espaces ouverts d'un motif de résist sur lesdites électrodes de connexion et électrodes de plage,
une première étape de placage comprenant la formation d'une partie ou de l'ensemble d'une couche plaquée de base sur les électrodes exposées dans lesdits espaces ouverts dudit motif de résist,
une étape de masquage de résist comprenant la formation d'un masque sur lesdites électrodes de plage au côté inférieur du substrat en résine pour empêcher la formation d'une couche plaquée or, et
une deuxième étape de placage comprenant la formation d'une couche plaquée de base restante et d'une couche plaquée or ou, uniquement, d'une couche plaquée or, sur ladite couche plaquée de base formée sur lesdites électrodes de connexion.

12. Procédé de fabrication d'un dispositif à semiconducteur avec des bosses de soudure tel que revendiqué dans la revendication 11, dans lequel ladite couche plaquée de base dans ladite première étape de placage est une couche plaquée cuivre, et le placage métal dans ladite deuxième étape de placage comprend la formation d'une couche à placage multiple constituée d'une couche plaquée nickel, d'une couche plaquée or flash et d'une couche plaquée or.

13. Procédé de fabrication d'un dispositif à semiconducteur avec des bosses de soudure tel que revendiqué dans la revendication 11, où le placage de ladite couche plaquée de base dans ladite première étape de placage comprend la formation d'une couche à placage multiple constituée d'une couche plaquée cuivre et d'une couche plaquée nickel, et le placage de ladite deuxième étape de placage comprend la formation d'une couche à placage multiple constituée d'une couche plaquée or flash et d'une couche plaquée or.

14. Procédé de fabrication d'un dispositif à semiconducteur avec des bosses de soudure tel que revendiqué dans la revendication 11, dans lequel le placage de ladite couche plaquée de base dans ladite première étape de placage comprend la formation d'une couche à placage multiple constituée d'une couche plaquée cuivre, d'une couche plaquée nickel et d'une couche plaquée or flash, et le placage de ladite deuxième étape de placage comprend la formation d'une couche plaquée or.

15. Procédé de fabrication d'un dispositif à semiconducteur avec des bosses de soudure selon la revendication 11, incluant en outre
une étape pour retirer ledit masque de résist du côté inférieur dudit substrat en résine,
une étape de masquage de résist comprenant la formation d'un masque de résist sur le côté supérieur dudit substrat en résine, et une étape pour former une couche plaquée argent sur lesdites électrodes de plage sur le côté inférieur dudit substrat en résine.

16. Procédé de fabrication d'un dispositif à semiconducteur avec des bosses de soudure selon la revendication 11, incluant en outre
une étape pour retirer ledit masque de résist du côté inférieur dudit substrat en résine, et
une étape pour former un film anti-oxydation sur lesdites électrodes de plage sur le côté inférieur dudit substrat en résine.
